# FASCICULE DE BREVET EUROPEEN

(11) **EP 2 446 462 B1**
(45) Date de publication et mention de la délivrance du brevet: **03.04.2019**
(21) Numéro de dépôt: 10745304.5
(22) Date de dépôt: 23.06.2010
(51) Int. Cl.: H01L 21/67

(54) **APPAREIL DE FABRICATION DE GALETTES DE SEMI-CONDUCTEUR ET APPAREIL DE DEPOT PAR EVAPORATION DE MATERIAUX PAR JET MOLECULAIRE**
VORRICHTUNG ZUR HERSTELLUNG VON HALBLEITERWAFERN UND VORRICHTUNG ZUR ABLAGERUNG VON MATERIALIEN DURCH VERDAMPFUNG MIT EINEM MOLEKULAREN STRAHL
APPARATUS FOR FABRICATING SEMICONDUCTOR WAFERS AND APPARATUS FOR THE DEPOSITION OF MATERIALS BY EVAPORATION USING A MOLECULAR BEAM

(30) Priorité: 23.06.2009 FR 0954254
(43) Date de publication de la demande: 02.05.2012
(73) Titulaire: Riber, 95870 Bezons (FR)
(72) Inventeur: VILLETTE, Jerôme, F-92350 Le Plessis Robinson (FR); CASSAGNE, Valerick, F-91470 Limours En Hurepoix (FR); PICAULT, Michel, F-92100 Boulogne-billancourt (FR)
(74) Mandataire: Jacobacci Coralis Harle
(86) Numéro de dépôt international: PCT/FR2010/051280
(87) Numéro de publication internationale: WO 2010/149931

(56) Documents cités:
- EP-A- 1 235 258
- JP-A- 2001 223 077
- US-A- 5 478 400
- US-A1- 2005 115 671
- US-A1- 2009 016 853
- US-A1- 2009 032 056
- US-A1- 2010 255 184

## Description

L'invention se rapporte au domaine de la microélectronique.

Elle concerne plus particulièrement un appareil de fabrication de galettes de semi-conducteur et un appareil de dépôt par évaporation de matériaux par jet moléculaire pour la fabrication de galettes de semi-conducteur.

La plupart des composants électroniques et microélectroniques tels que les mémoires magnétiques, les circuits CMOS ou les processeurs sont réalisés à l'aide d'empilements de couches de matériaux minces et de très grande pureté. Les matériaux déposés sont, par exemple, des conducteurs (métaux), des semi-conducteurs (silicium, germanium, composés du type III-V ou II-IV, par exemple) ou des isolants (oxydes, nitrure, par exemple). Ils sont déposés sur des substrats de silicium ou de germanium ou d'autres matériaux. Ces substrats sont en forme de disque avec des diamètres de 200 mm ou 300 mm. D'autres formes de substrat sont également possibles.

Chaque substrat subit plusieurs étapes de traitement comme le dépôt d'une ou plusieurs couches de matériaux, le traitement thermique et la gravure. On obtient alors un disque ou une galette de semi-conducteur qui sera ensuite traité pour obtenir une multitude de composants électroniques.

Dans l'industrie microélectronique, ces étapes sont classiquement réalisées dans un système multi chambres sous vide (jusqu'à environ 10⁻⁷ Torr). Chacune des étapes du process est réalisée dans une chambre ou module distinct. Chaque chambre est associée à une opération de dépôt de couche de matériaux, de traitement thermique ou de gravure. Un bras robotisé placé dans une enceinte sous vide distribue les substrats d'une chambre à une autre.

Il est ainsi connu du document EP 1235258 un appareil de fabrication de galettes de semi-conducteur selon le préambule de la revendication 1.

Les besoins technologiques de réduction d'échelle des composants électroniques et d'amélioration des performances des circuits intégrés en terme de consommation électrique et de vitesse, nécessitent la réalisation de couches de matériaux plus minces avec des matériaux nouveaux, d'une pureté ou d'une qualité structurelle (cristalline) supérieure.

L'utilisation d'alliages semi-conducteurs tels les semi-conducteurs du type III-V ou II-VI, et le dépôt de couches de matériaux de quelques couches atomiques d'un matériau de grande qualité peuvent répondre à ces besoins.

Les techniques connues de dépôt par évaporation de matériaux par jet moléculaire telles les techniques du type dépôt par épitaxie par jets moléculaires (MBE « molecular beam epitaxy ») ou dépôt par jet moléculaire (MBD « molecular beam déposition ») permettent d'atteindre ces performances.

Ces techniques nécessitent des conditions d'ultravide, c'est à dire une pression dans les chambres de réaction inférieure à 10⁻⁹ Torr pour éviter la contamination du substrat, des différentes couches, et des différentes interfaces.

Il a été envisagé d'effectuer des dépôts de couches minces sur un substrat dans un appareil de dépôt par évaporation de matériaux par jet moléculaire, puis de transférer le substrat dans un autre appareil qui est un système multi chambres utilisés dans l'industrie microélectronique pour y effectuer d'autres dépôts ou traitements. Mais l'exposition des couches et interfaces à des hauts vides ou des atmosphères neutres ou à l'air, entre les dépôts ou traitements, nuit à la qualité finale des dispositifs électroniques
Les techniques connues de dépôt par évaporation de matériaux par jet moléculaire sont incompatibles avec les systèmes multi chambres classiques utilisés dans l'industrie microélectronique.

En effet, les techniques de dépôt par évaporation de matériaux par jet moléculaire utilisent généralement une seule chambre de dépôt capable de déposer de nombreux matériaux et alliages, AsGa, InGaAs, InP, dopé ou non, par exemple, alors que les systèmes multi chambres utilisés dans l'industrie microélectronique requièrent plusieurs chambres de réaction dans lesquelles sont déposées en générale un matériau ou alliage et parfois plusieurs, mais toujours en nombre limité pour éviter les contaminations parasites.

De plus, pour pouvoir être utilisés dans les lignes de fabrication de l'industrie du silicium, les systèmes multi chambres doivent répondre aux normes SEMI. Notamment, ces systèmes doivent fonctionner dans des conditions de vide ou de pression supérieur à 10⁻⁸ Torr. La taille des substrats est normalisée (200, 300, ou 450 mm de diamètre). Il existe également des contraintes au niveau des dimensions des chambres, de l'électronique et des logicielles commandant les différents équipements (robots, sources, par exemple).

Les systèmes de MBE ou MBD utilisent généralement des matériaux solides placés dans des creusets (ou sources d'évaporation) et qui sont évaporés sous vide par chauffage à l'aide de filaments ou par bombardement électronique. La plupart des matériaux étant à l'état liquide lors de l'évaporation, le creuset est généralement placé plus ou moins verticalement en bas de la chambre de réaction. Le substrat est placé au dessus des creusets avec la face à traiter faisant face aux sources d'évaporation, c'est-à-dire orientée vers le bas.

Au contraire, dans les systèmes multi chambres utilisés dans l'industrie microélectronique, le substrat est positionné avec sa face à traiter dirigée vers le haut.

De plus, les réacteurs des systèmes de MBE ou MBD sont encombrants car ils utilisent un grand nombre de source d'évaporation et ont une grande géométrie sources/substrats afin de réaliser des dépôts avec des épaisseurs d'une grande précision pouvant aller jusqu'à une couche atomique, sur des grandes surfaces pouvant aller jusqu'à 500 mm de diamètre, ceci entrainant des réacteurs d'un grand diamètre. Il est impossible de les intégrer en l'état dans un système multi chambres utilisé dans l'industrie microélectronique.

Un des objectifs de l'invention est donc de fournir un appareil de dépôt par évaporation de matériaux par jet moléculaire pour la fabrication de galettes de semi-conducteur plus compact, et compatible avec les systèmes multi chambres de l'industrie microélectronique.

Un autre objectif de l'invention est de fournir un appareil de fabrication de galettes de semi-conducteur permettant de réaliser toutes les étapes de dépôts et de traitements sur la galette de semi-conducteur in situ.

À cet effet, l'invention propose un appareil de fabrication de galettes de semi-conducteur tel qu'énoncé dans la revendication 1 de la présente demande.

D'autres caractéristiques non limitatives et avantageuses de l'appareil de fabrication de galettes de semi-conducteur conforme à l'invention sont énoncées dans les revendications 2 et 3.

L'invention fournit ainsi un appareil de fabrication de galettes de semi-conducteur compact et permettant de réaliser toutes les étapes de dépôts et de traitements sur la galette de semi-conducteur in situ et sous vide, sans transfert du substrat d'un appareil à un autre.

Cet arrangement en chambre multiple permet également d'obtenir une forte productivité car les étapes sont réalisées successivement sans transport du substrat vers un autre système externe, tel un système de dépôt MBE.

Il est possible de déposer des matériaux semi-conducteurs épitaxiés (monocristallins), des métaux (polycristallins) et des isolants (amorphes) dans un même appareillage, et dans des conditions d'ultravide.

Il est possible de réaliser des empilements de couches en maintenant les interfaces extrêmement propres, et des empilements nouveaux.

La réalisation de transistors hautes performances est possible, en déposant un empilement de matériaux composé de type III-V (AsGa) ou II-VI, par exemple, sur une couche de Silicium/Germanium, puis un oxyde de grille à haute permittivité (La₂Hf₂O₇ par exemple), et un métal binaire (de type TaN par exemple).

Les couches minces de matériaux obtenues sont de faible épaisseur (quelques couches atomiques jusqu'à une couche atomique) et présentent des interfaces résolues à la monocouche atomique près et une grande uniformité d'épaisseur, de composition ou de dopage sur des grandes surfaces.

L'appareil de fabrication de galettes de semi-conducteur permet également d'éviter les contaminations métalliques.

L'invention sera décrite plus en détail en référence aux dessins annexés dans lesquels :
- la figure 1 représente un appareil de fabrication de galettes de semi-conducteur, selon un mode de réalisation possible de l'invention,
- la figure 2 représente une vue en coupe longitudinale d'un appareil ou module de dépôt par jet moléculaire, selon un mode de réalisation possible de l'invention,
- la figure 3 représente la vue de dessus de cet appareil ou module de dépôt par jet moléculaire,
- la figure 4 représente un appareil de fabrication de galettes de semi-conducteur, selon un autre mode de réalisation de l'invention,
- la figure 5 représente un module de retournement selon un premier arrangement possible,
- la figure 6 représente un module de retournement selon un deuxième arrangement possible,
- la figure 7 représente un module de retournement selon un troisième arrangement possible,
- la figure 8 représente le détail d'un module de retournement, selon un mode de réalisation possible de l'invention.

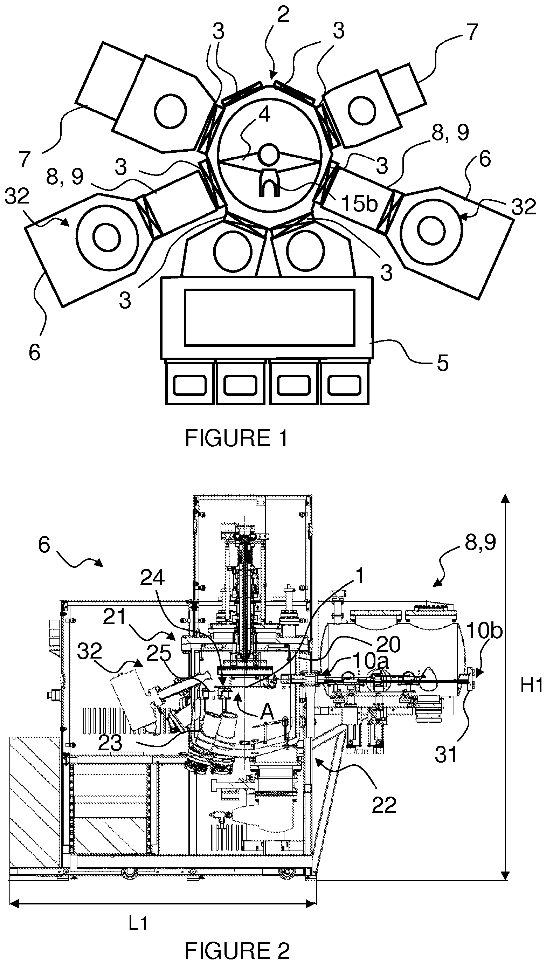

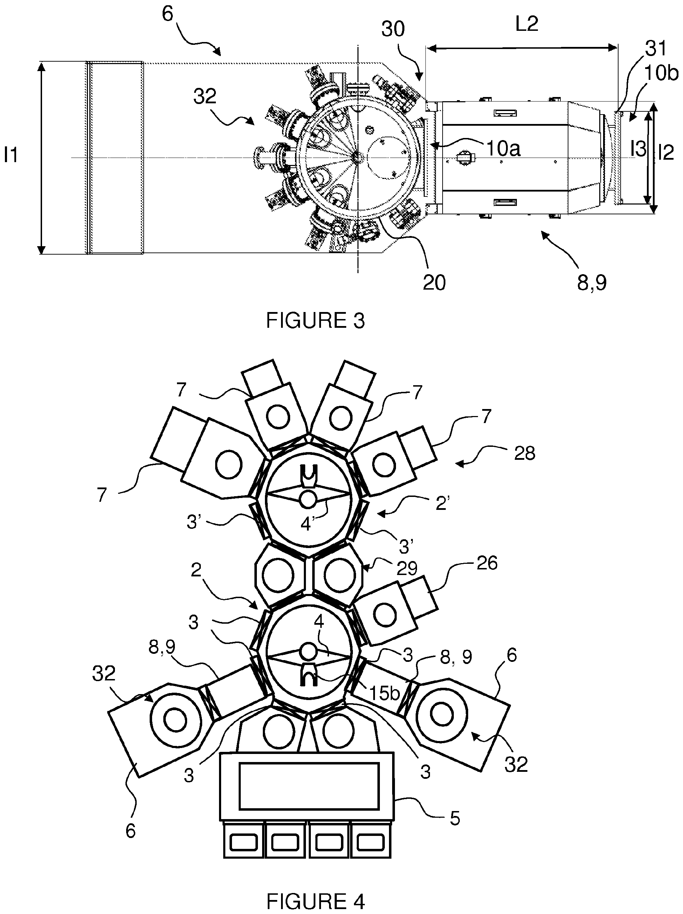

Sur les figures 2 et 3, les éléments non essentiels à la compréhension de l'invention n'ont pas été référencés.

La figure 1 représente un appareil de fabrication de galettes de semi-conducteur, selon un mode de réalisation possible de l'invention.

On entend par galette de semi-conducteur, un substrat 1 recouvert d'au moins une couche de matériaux et ayant subi différentes opérations pour obtenir un disque qui sera ensuite traité pour obtenir une multitude de dispositifs électroniques ou microélectroniques tels des mémoires magnétiques, des circuits logiques (transistors, microprocesseurs, DRam), des détecteurs infrarouges, des diodes électroluminescentes bleues, des diodes lasers, des capteurs, ou des composants RF, par exemple. Le substrat 1 comprend une face à traiter A et une face non traitée B.

L'appareil de fabrication comprend plusieurs modules ou chambres dont un module de convoyage central 2 comportant plusieurs ports latéraux 3 et des moyens de convoyage 4 aptes à convoyer le substrat 1 d'un port latéral 3 à un autre. Le module de convoyage central 2 est apte à fonctionner dans des conditions de vide ou pression supérieur à 10⁻⁸ Torr. Le module de convoyage central 2 est conforme aux normes SEMI.

On entend par ports latéraux 3 des ouvertures aptes à communiquer de façon étanche avec un module. Ces ouvertures sont préférentiellement de forme rectangulaire et peuvent être fermées par une vanne.

Les moyens de convoyage 4 comprennent un support 15b apte à supporter le substrat 1 et à être mobile en rotation. Les moyens de convoyage 4 sont positionnés au centre du module de convoyage central 2. Le support 15b est également mobile en translation. Les moyens de convoyage 4 permettent de positionner le substrat devant un port 3 sélectionné. La vanne du port 3 étant ouverte, le support est translaté vers le module associé au port 3 pour y déposer le substrat 1.

Dans l'exemple de la figure 1, le module de convoyage central 2, est relié à une pompe secondaire permettant d'atteindre une pression d'environ 2x10⁻⁸ Torr.

L'appareil de fabrication comprend également un module de chargement 5 connecté à un ou plusieurs ports 3 du module de convoyage central 2. Le module de chargement 5 est apte à recevoir un ou plusieurs substrats 1 de silicium ou de germanium ou autre, de 200, 300, ou 450 mm de diamètre, par exemple, avant leur transfert vers les différents modules. Le module de chargement 5 est conforme aux normes SEMI.

L'appareil de fabrication comprend un ou plusieurs modules de traitement du substrat 7 fonctionnant dans des conditions de vide supérieur à 10⁻⁸ Torr. Chaque module de traitement 7 est connecté à l'un des ports 3 du module de convoyage central 2 et est apte à recevoir le substrat 1 pour effectuer une opération de traitement sur sa face à traiter A.

Chaque module de traitement du substrat 7 comprend au moins un système de dépôt CVD (« Chemical Vapor Deposition »), PECVD (« Plasma Enhanced Chemical Vapor Déposition »), PVD (« Physical Vapor Déposition »), MOCVD (« Metal Organique Chemical Vapor Deposition »), de traitement thermique ou de gravure ou autre.

Ces modules de traitement du substrat 7 sont des modules classiquement utilisés dans l'industrie microélectronique et répondent aux normes SEMI.

Dans ces modules de traitement du substrat 7, le substrat 1 est positionné en bas du module avec sa face à traiter A dirigée vers le haut.

Les différents modules ci-dessus forment un système multi chambres utilisés dans l'industrie microélectronique.

L'appareil de fabrication comprend au moins un module de dépôt par évaporation de matériaux par jet moléculaire 6 fonctionnant dans des conditions de vide ou de pression inférieur à 10⁻⁸ Torr. Chaque module de dépôt par jet moléculaire 6 est connecté à l'un des ports 3 du module de convoyage central 2 et apte à recevoir le substrat 1 pour déposer une couche de matériaux sur sa face à traiter A.

Chaque module ou appareil de dépôt par évaporation de matériaux par jet moléculaire 6 comprend un réacteur MBE ou MBD 32.

La figure 2 représente une vue en coupe longitudinale d'un module ou appareil de dépôt par évaporation de matériaux par jet moléculaire 6 comprenant un réacteur MBE 32.

Le réacteur MBE 32 comprend une chambre de réaction 20 comprenant une partie supérieure 21 et une partie inférieure 22.

Le réacteur MBE 32 comprend au moins une source de matériaux 23 positionnée dans la partie inférieure de la chambre de réaction 22 et dirigée vers sa partie supérieure 21. La source de matériaux 23 peut être un creuset entouré d'un filament ou un creuset destiné à subir un bombardement électronique pour évaporer le matériau à vaporiser.

Le réacteur MBE 32 comprend un porte échantillon 24 positionné dans la partie supérieure 21 de la chambre de réaction et apte à supporter le substrat 1 de façon à ce que ce dernier présente sa face à traiter A orientée vers la ou les sources de matériaux 23.

La plupart des matériaux étant à l'état liquide lors de l'évaporation, le creuset est placé plus ou moins verticalement en bas de la chambre de réaction.

Le réacteur MBE 32 comprend des volets 25 pour obturer les sources de matériaux 23.

Le réacteur MBE 32 comprend des moyens de pompage (non illustrés) aptes à fournir des conditions de vide inférieur à 10⁻⁸ Torr dans la chambre de réaction. La pression dans la chambre de réaction 22 est préférentiellement inférieure à 10⁻⁹ Torr.

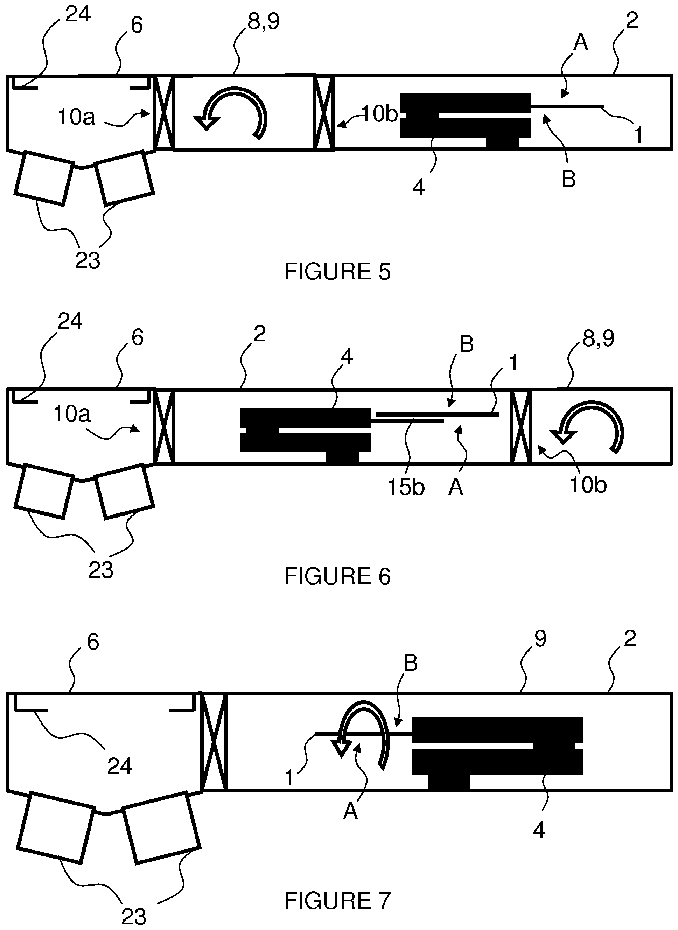

Le module de dépôt par évaporation de matériaux par jet moléculaire 6 comprend un sas 8 le reliant à l'un des ports 3 du module de convoyage central 2. Plus précisément, le sas 8 relie l'un des ports 3 du module de convoyage central 2 à la chambre de réaction 20 du module de dépôt par évaporation de matériaux par jet moléculaire 6, comme illustré sur la figure 5.

Le sas 8 permet de rendre compatible la pression entre le module de dépôt par évaporation de matériaux par jet moléculaire 6 et le module de convoyage central 2.

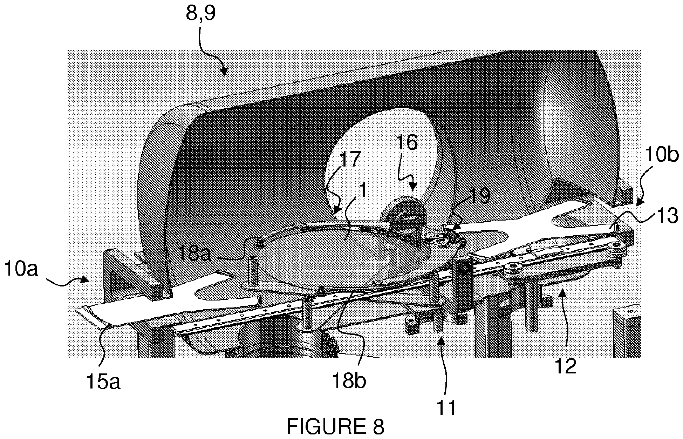

Comme illustré sur la figure 8, le sas 8 comprend une ouverture 10a, 10b, à chacune de ses extrémités latérales, et des moyens de pompage lui permettant d'être ouvert alternativement sur des modules dont les conditions de vide sont inférieur à 10⁻⁸ Torr ou les conditions de vide sont supérieur à 10⁻⁸ Torr. Ces moyens de pompage comprennent des pompes primaires et secondaires. Un capteur de pression est également prévu. Chaque ouverture 10a, 10b peut être fermée par une vanne de façon étanche, et est préférentiellement de forme rectangulaire.

Le sas 8 permet de mettre en communication le module de convoyage central 2 et le module de dépôt par évaporation de matériaux par jet moléculaire 6 qui sont à des pressions différentes. Le sas 8 répond aux normes SEMI.

L'appareil de fabrication de galettes de semi-conducteur comprend un module de retournement 9 apte à retourner la face à traiter A du substrat 1 vers le haut lorsque le substrat 1 est destiné à être transféré vers un module de traitement 7, ou vers le bas lorsque le substrat 1 est destiné à être transféré vers un module de dépôt par évaporation par jet moléculaire 6.

Selon un mode de réalisation de l'invention, le sas 8 comprend le module de retournement 9, comme illustré sur les figures 1 à 5, et 8.

Dans le module de dépôt par évaporation par jet moléculaire 6, le substrat 1 est positionné au niveau de la partie supérieur du module 21, et la face à traiter A du substrat 1 est orientée vers la partie inférieure du module 22 de dépôt par évaporation par jet moléculaire 6. Et, dans le module de traitement du substrat 7, la face à traiter A du substrat 1 est orientée vers la partie supérieure du module de traitement 7. Le module de retournement 9 permet ainsi d'orienter la face à traiter A du substrat 1 en fonction du module destiné à effectuer une opération sur cette face A.

Comme illustré sur la figure 8, le module de retournement 9 comprend un moyen de retournement 11, et un moyen de déplacement longitudinal 12 disposé entre une des ouvertures 10a, 10b du module de retournement 9 et le moyen de retournement 11. Cette ouverture 10b est en communication avec la chambre de réaction 20 du module de dépôt par évaporation de matériaux par jet moléculaire 6.

Le moyen de déplacement longitudinal 12 comporte un support 13 apte à supporter le substrat 1, et à être mobile entre une position de déchargement ou de chargement du substrat 1 par le moyen de retournement 11, et une position d'évacuation ou de réception du substrat 1 à travers l'une des ouvertures du module de retournement 10a, 10b. Plus précisément, cette ouverture 10a, 10b correspond à celle qui est en communication avec la chambre de réaction 20 du module de dépôt par évaporation de matériaux par jet moléculaire 6.

Le moyen de retournement 11 est apte à saisir le substrat 1 positionné sur le support 13 du moyen de déplacement longitudinal, à pivoter autour d'un axe horizontal pour retourner le substrat 1, et à le décharger sur un support fixe 15a. Un autre support mobile longitudinalement 15b est apte à saisir le substrat 1 du support fixe 15a. Cet autre support mobile longitudinalement 15b est solidaire du module de convoyage central 2.

Le moyen de retournement 11 comprend une articulation 16 pour retourner le substrat 1 et des moyens de préhension 17 pour saisir et relâcher le substrat 1. Les moyens de préhension 17 comportent deux bras semi circulaires 18a, 18b, ou presque, formant une tenaille, et des moyens d'articulation 19 pour permettre le resserrement ou le desserrement des bras semi circulaires 18a, 18b lorsque le moyen de retournement 11 est en position de chargement ou de déchargement du substrat 1.

Les différents supports 13, 15a et 15b ont des dimensions adaptées à des substrats 1 ayant des diamètres de 200 mm ou 300 mm, ou autres.

La figure 8 représente un exemple de module ou appareil de dépôt par évaporation de matériaux par jet moléculaire 6 comprenant un tel module de retournement 9. Ce module de dépôt par évaporation de matériaux par jet moléculaire 6 est entouré d'un carter de protection.

Ce qui suit décrit un exemple de fonctionnement du module de retournement 9 ou sas 8.

Après avoir été chargé sur le support 15b du module de convoyage central 2, le substrat 1 est amené devant le port 3 associé à un module de dépôt par évaporation de matériaux par jet moléculaire 6 par le module de convoyage central 2. La pression dans le module de convoyage central 2 est de 10⁻⁷ Torr et la face à traiter A du substrat est orientée vers le haut.

La vanne du sas 8 associée au port 3 est ouverte et le substrat 1 est transféré dans le sas 8 par le support mobile 15b, la deuxième vanne du sas 8 associée à la chambre de réaction 20 du module de dépôt par évaporation de matériaux par jet moléculaire 6 étant fermée.

Le support mobile 15b dépose le substrat 1 sur le support fixe 15a. Le support mobile 15b revient dans le module de convoyage 2. La vanne du sas 8 associée au port 3 est fermée. Les moyens de pompage du sas 8 font baisser la pression dans ce dernier jusqu'à au moins 10⁻⁹ Torr.

Les deux bras semi circulaires 18a, 18b saisissent le substrat 1 du support fixe 15a. Les deux bras semi circulaires 18a, 18b effectuent une rotation à 180° de façon à retourner le substrat 1 sur le support 13 du moyen de déplacement longitudinal 12. La face à traiter A du substrat 1 est orientée vers le bas, c'est-à-dire face au support 13 du moyen de déplacement longitudinal 12.

La vanne du sas 8 associée à la chambre de réaction 20 du module de dépôt par évaporation de matériaux par jet moléculaire 6 est ouverte et le substrat 1 est translaté longitudinalement par le moyen de déplacement 12 pour être déposé sur le porte échantillon 24 du module de dépôt par évaporation de matériaux par jet moléculaire 6. La face à traiter A du substrat 1 est orientée vers le bas, c'est-à-dire vers la partie inférieure 22 de la chambre de réaction 20 du module de dépôt par évaporation de matériaux par jet moléculaire 6. Le moyen de déplacement 12 est translaté dans le sas 8.

La vanne du sas 8 associée à la chambre de réaction 20 du module de dépôt par évaporation de matériaux par jet moléculaire 6 est refermée, et les opérations de dépôt de couche de matériaux peuvent commencer.

De la même façon, après le dépôt terminé, le substrat 1 suit le chemin inverse en étant retourné de l'autre côté par le module de retournement 9.

La pression du sas 8 s'adapte à la pression du module de convoyage central 2, qui devient 2x10⁻⁸ Torr.

On obtient un module de dépôt par évaporation de matériaux par jet moléculaire 6 qui est compatible en pression avec les modules de traitement du substrat 7 et le module de convoyage central 2, fonctionnant dans des conditions de vide supérieur à 10⁻⁸ Torr.

D'autres modes de réalisation sont possibles concernant la position du module de retournement 9.

Le module de retournement 9 peut être intégré dans le module de convoyage central 2, comme illustré sur la figure 7.

Alternativement, le module de retournement 9 peut être positionné entre l'un des ports 3 du module de convoyage central 2 et l'un des modules de traitement du substrat 7, comme illustré sur la figure 6.

Comme représenté sur la figure 1, l'appareil de fabrication de galettes de semi-conducteur peut comprendre deux modules de dépôt par évaporation de matériaux par jet moléculaire 6, et deux modules de traitement du substrat 7.

La figure 4 représente un autre mode de réalisation dans lequel l'appareil de fabrication de galettes de semi-conducteur comprend un premier module de convoyage central 2 comportant plusieurs ports latéraux 3, un module de chargement 5 connecté à deux des ports 3 du module de convoyage central 2, et pouvant accueillir au moins 15 substrats. Ces derniers ayant un diamètre de 200 mm ou 300 mm.

L'appareil de fabrication de galettes de semi-conducteur comprend deux modules de dépôt par évaporation de matériaux par jet moléculaire 6 dont un module ayant une chambre de réaction 20 dédiée au dépôt d'une couche d'alliages semi-conducteurs (groupe III-V) à partir de sources d'Arsenic, de Gallium, d'Indium solides ou gazeuses, et un module ayant une chambre de réaction 20 dédiée au dépôt d'une couche d'oxyde (matériaux isolant et diélectrique). Cette dernière est équipée de sources de matériaux plasma et permet la nitruration ou l'oxydation des métaux.

L'appareil de fabrication de galettes de semi-conducteur comprend également un module d'analyse de surface 26.

L'appareil de fabrication de galettes de semi-conducteur comprend un ensemble de modules de traitement du substrat 28 comportant des deuxièmes moyens de convoyage 4', et un deuxième module de convoyage central 2' comportant plusieurs ports latéraux 3' reliés à un ou plusieurs ports latérales 3 du premier module de convoyage central 2.

Les ports latéraux 3', 3 des premier et deuxième moyens de convoyage 4, 4' présentent une interface de connection de forme rectangulaire munie d'une ouverture rectangulaire adaptée au passage d'un substrat 1 de 200 mm ou 300 mm de diamètre.

Le deuxième module de convoyage central 2' est en communication avec plusieurs modules de traitement du substrat 7 dont au moins un module de dépôt PVD et un module de gravure, par l'intermédiaire d'un module de transfert intermédiaire 29. Ce module de transfert intermédiaire 29 permet le transfert du substrat 1 d'un module de convoyage central 2, 2' à un autre.

Le module de gravure permet de préparer la surface de couche d'oxyde.

Le module de dépôt PVD permet de déposer des couches métalliques pour réaliser des électrodes conductrices par-dessus la couche d'oxyde.

Un module d'analyse peut être prévu pour permettre de réaliser des caractérisations par rayon X (XPS) ou par faisceau d'électrons (du type RHEED) ou par champs proches (AFM, STM).

L'arrangement décrit ci-dessus est un exemple possible. D'autres arrangements sont également possibles.
L'appareil de fabrication de galettes de semi-conducteur permet de déposer des éléments comme le Si, Hf, Ta, La, Ti, As, Ga, Sb, et le In, par exemple. Il est possible de réaliser des dépôts réactifs en formant du TaN, TiN, HfO2, par exemple.

L'appareil ou module de dépôt par jet moléculaire 6 pour la fabrication de galettes de semi-conducteur présente de faibles dimensions par rapport aux appareils connus. Sa hauteur est inférieure à 3,5 m. Sa longueur est inférieure à 2,8 m et sa largeur est inférieure à 1,2 m. Son poids est inférieur à 6000 kg.

Les dimensions du module de dépôt par jet moléculaire 6 répondent aux normes SEMI et plus particulièrement à la norme SEMI E72-0600.

Dans l'exemple des figures 2 et 3, le module de dépôt par jet moléculaire 6, muni de son ou ses carters de protection, présente une longueur L1 de 1844,5 mm, une largeur I1 de 1000 mm et une hauteur H1 de 2367 mm.

Le module de retournement 9, muni de son carter de protection, présente une longueur L2 de 998,5 mm, et une largeur I2 de 582 mm.

Le module de retournement 9 comprend une interface de connection 31 comportant l'ouverture du module de retournement 10b destinée à être associée à un module de dépôt par jet moléculaire 6. Cette interface de connection 31 présente une largeur I3 de 480 mm.

L'ensemble module de dépôt par jet moléculaire 6 et module de retournement 9 présente une longueur totale Lₜₒₜₐₗₑ d'environ 2763 mm.

Par rapport aux systèmes de l'art antérieur, le module de dépôt par jet moléculaire 6 de l'invention présente des sources de matériaux 23 et autres éléments, comme les injecteurs de gaz précurseur, agencés différemment autour de ce dernier.

Les différentes sources de matériaux 23 ne sont pas réparties régulièrement autour de la chambre de réaction 20 du module de dépôt par jet moléculaire 6.

Une zone en périphérie de la chambre de réaction 30 est prévue sans source de matériaux 23 ou autre éléments pour permettre l'accès au sas 8 et faciliter les opérations de maintenance sur les sources de matériaux 23 et le sas 8.

## Revendications

1. Appareil de fabrication de galettes de semi-conducteur comprenant un substrat (1) recouvert d'au moins une couche de matériaux, ledit substrat (1) comprenant une face à traiter (A) et une face non traitée (B), ledit appareil de fabrication comprenant :
- un module de convoyage central (2) comportant plusieurs ports latéraux (3) et des moyens de convoyage (4) aptes à convoyer ledit substrat (1) d'un port latéral (3) à un autre, ledit module de convoyage central (2) étant apte à fonctionner dans des conditions de vide supérieur à 10⁻⁸ Torr,
- un module de chargement (5) connecté à un ou plusieurs ports (3) du module de convoyage central (2), ledit module de chargement (5) étant apte à recevoir un ou plusieurs substrats (1),
- un ou plusieurs modules de traitement du substrat (7) fonctionnant dans des conditions de vide supérieur à 10⁻⁸ Torr, chaque module de traitement (7) étant connecté à l'un des ports (3) du module de convoyage central (2) et apte à recevoir ledit substrat (1) pour effectuer une opération de traitement sur sa face à traiter (A), au moins un desdits modules de traitement du substrat (7) comprenant un système de dépôt de matériaux,
**caractérisé en ce qu'**il comprend :
- au moins un module de dépôt par évaporation de matériaux par jet moléculaire (6) fonctionnant dans des conditions de vide inférieur à 10⁻⁸ Torr, ledit module de dépôt par jet moléculaire (6) étant connecté à l'un des ports (3) du module de convoyage central (2) et apte à recevoir ledit substrat (1) pour déposer une couche de matériaux sur sa face à traiter (A), ledit module de dépôt par évaporation de matériaux par jet moléculaire (6) comprend un sas (8) le reliant à l'un des ports (3) du module de convoyage central (2), ledit sas (8) permettant de rendre compatible la pression entre le module de dépôt par évaporation de matériaux par jet moléculaire (6) et le module de convoyage central (2), ledit sas (8) comprenant une ouverture (10a, 10b) à chacune de ses extrémités latérales apte à être fermée par une vanne, et des moyens de pompage aptes à fournir des conditions de vide inférieur à 10⁻⁸ Torr et des conditions de vide supérieur à 10⁻⁸ Torr, à l'intérieur du sas (8) et
- un module de retournement (9) apte à retourner la face à traiter (A) du substrat (1) :
- vers le haut lorsque le substrat (1) est destiné à être transféré vers un module de traitement (7), dans lequel la face à traiter (A) du substrat (1) est orientée vers la partie supérieure dudit module de traitement (7), ou
- vers le bas lorsque le substrat (1) est destiné à être transféré vers un module de dépôt par évaporation par jet moléculaire (6) dans lequel la face à traiter (A) du substrat (1) est orientée vers la partie inférieure (22) dudit module (6),
- ledit module de retournement (9) étant positionné entre l'un des ports (3) du module de convoyage central (2) et l'un des modules de dépôt par évaporation par jet moléculaire (6), ledit module de retournement (9) étant intégré dans ledit sas (8), et
- ledit module de retournement (9) comprenant un moyen de retournement (11), et un moyen de déplacement longitudinal (12) disposé entre une desdites ouvertures (10a, 10b) du module de retournement (9) et le moyen de retournement (11), le moyen de déplacement longitudinal (12) comportant un support (13) apte à supporter le substrat (1), et à être mobile entre une position de déchargement ou de chargement du substrat (1) par le moyen de retournement (11), et une position d'évacuation ou de réception du substrat (1) à travers l'une des ouvertures du module de retournement (10a, 10b), ledit moyen de retournement (11) étant apte à saisir le substrat (1) positionné sur le support (13) du moyen de déplacement longitudinal, à pivoter autour d'un axe horizontal pour retourner le substrat (1), et à le décharger sur un autre support (15a).

2. Appareil de fabrication de galettes de semi-conducteur selon la revendication 1, **caractérisé en ce que** le moyen de retournement (11) comprend des moyens de pivotement (16) pour retourner le substrat et des moyens de préhension (17) pour saisir et relâcher le substrat (1), lesdits moyens de préhension (17) comportant deux bras semi circulaires (18a, 18b) formant une tenaille, et des moyens d'articulation (19) pour permettre le resserrement ou le desserrement des bras semi circulaires (18a, 18b) lorsque le moyen de retournement (11) est en position de chargement ou de déchargement du substrat (1).

3. Appareil de fabrication de galettes de semi-conducteur selon la revendication 1 ou 2, **caractérisé en ce que** le ou les modules de traitement du substrat (7) comprennent au moins un système de dépôt CVD, PECVD, PVD, MOCVD ou de gravure.

## Patentansprüche

1. Vorrichtung zur Herstellung von Halbleiterwafern, die ein mit wenigstens einer Lage Materialien bedecktes Substrat (1) aufweisen, wobei das Substrat (1) eine zu bearbeitende Seite (A) und eine nicht bearbeitete Seite (B) aufweist, wobei die Herstellungsvorrichtung
- ein zentrales Transportmodul (2), das mehrere seitliche Stationen (3) und Transportmittel (4), die geeignet sind, das Substrat (1) von einer seitlichen Station (3) zu einer anderen zu transportieren, aufweist, wobei das zentrale Transportmodul (2) geeignet ist, unter den Bedingungen eines Vakuums von mehr als 10⁻⁸ Torr zu funktionieren,
- ein Beladungsmodul (5), das mit einer oder mehreren Stationen (3) des zentralen Transportmoduls (2) verbunden ist, wobei das Beladungsmodul (5) geeignet ist, ein oder mehrere Substrate (1) aufzunehmen,
- ein oder mehrere Module (7) zum Bearbeiten des Substrats, die unter den Bedingungen eines Vakuums von mehr als 10⁻⁸ Torr funktionieren, wobei jedes Bearbeitungsmodul (7) mit einer der Stationen (3) des zentralen Transportmoduls (2) verbunden ist und geeignet ist, das Substrat (1) aufzunehmen, um einen Bearbeitungsvorgang auf dessen zu bearbeitender Seite (A) durchzuführen, wobei wenigstens eins der Module (7) zum Bearbeiten des Substrats ein System zur Ablagerung von Materialien aufweist,
aufweist,
**dadurch gekennzeichnet, daß** sie folgendes aufweist:
- wenigstens ein Modul (6) zur Ablagerung von Materialien durch Verdampfung mit einem molekularen Strahl, das unter den Bedingungen eines Vakuums von weniger als 10⁻⁸ Torr funktioniert, wobei das Modul (6) zum Ablagern durch molekularen Strahl mit einer der Stationen (3) des zentralen Transportmoduls (2) verbunden ist und geeignet ist, das Substrat (1) aufzunehmen, um eine Schicht von Materialien auf dessen zu bearbeitender Seite (A) abzulagern, wobei das Modul (6) zur Ablagerung von Materialien durch Verdampfung mit einem molekularen Strahl eine Schleuse (8), die es mit einer der Stationen (3) des zentralen Transportmoduls (2) verbindet, wobei die Schleuse (8) ermöglicht, den Druck zwischen dem Modul (6) zur Ablagerung von Materialien durch Verdampfung mit einem molekularen Strahl und dem zentralen Transportmodul (2) anzugleichen, wobei die Schleuse (8) an jedem ihrer seitlichen Enden eine Öffnung (10a, 10b) aufweist, die durch einen Schieber geschlossen werden kann, und Pumpmittel, die dazu ausgelegt sind, im Inneren der Schleuse (8) Bedingungen eines Vakuums von weniger als 10⁻⁸ Torr und Bedingungen eines Vakuums von mehr als 10⁻⁸ Torr zu schaffen, aufweist,
und
- ein Modul (9) zum Umdrehen, das geeignet ist, die zu behandelnde Seite (A) des Substrats (1)
- nach oben zu drehen, wenn das Substrat (1) dazu bestimmt ist, zu einem Behandlungsmodul (7) verlegt zu werden, in dem die zu behandelnde Seite (A) des Substrats (1) zum oberen Teil des Behandlungsmoduls (7) hin gerichtet ist, oder
- nach unten zu drehen, wenn das Substrat (1) dazu bestimmt ist, zu einem Modul (6) zur Ablagerung von Materialien durch Verdampfung mit einem molekularen Strahl verlegt zu werden, in dem die zu behandelnde Seite (A) des Substrats (1) zum unteren Teil (22) des Behandlungsmoduls (7) hin gerichtet ist,
- wobei das Modul (9) zum Umdrehen zwischen einer der Stationen (3) des zentralen Transportmoduls (2) und einem der Module (6) zur Ablagerung von Materialien durch Verdampfung mit einem molekularen Strahl positioniert ist, wobei das Modul (9) zum Umdrehen in der Schleuse (8) integriert ist, und
- wobei das Modul (9) zum Umdrehen ein Mittel (11) zum Umdrehen und ein Mittel (12) zum längs gerichteten Verlagern, das zwischen einer der Öffnungen (10a, 10b) des Moduls (9) zum Umdrehen und dem Mittel (11) zum Umdrehen angeordnet ist, aufweist, wobei das Mittel (12) zum längs gerichteten Verlagern einen Träger (13) aufweist, der dazu ausgelegt ist, das Substrat (1) zu tragen und zwischen einer Position zum Entladen bzw. zum Laden durch das Mittel (11) zum Umdrehen und einer Position zum Abführen bzw. Aufnehmen des Substrats (1) durch eine der Öffnungen (10a, 10b) des Moduls zu Umdrehen hindurch beweglich zu sein, wobei das Mittel (11) zum Umdrehen dazu ausgelegt ist, das auf dem Träger (13) des Mittels zum längs gerichteten Verlagern positionierte Substrat (1) zu erfassen, um eine horizontale Achse zu schwenken, um das Substrat (1) umzudrehen, und es auf einem anderen Träger (15a) abzulegen.

2. Vorrichtung zur Herstellung von Halbleiterwafern gemäß Anspruch 1, **dadurch gekennzeichnet, daß** das Mittel (11) zum Umdrehen Mittel (16) zum Schwenken, um das Substrat umzudrehen, und Mittel (17) zum Erfassen, um das Substrat (1) zu erfassen und loszulassen, aufweist, wobei die Mittel (17) zum Erfassen zwei halbkreisförmige, eine Zange bildende Arme (18a, 18b) und Gelenkmittel (19) zum Zusammenbringen und zum Auseinanderbringen der halbkreisförmigen Arme (18a, 18b), wenn das Mittel (11) zum Umdrehen in der Position zum Laden bzw. Entladen des Substrats (1) ist, aufweist.

3. Vorrichtung zur Herstellung von Halbleiterwafern gemäß Anspruch 1 oder 2, **dadurch gekennzeichnet, daß** das Modul bzw. die Module (7) zum Behandeln des Substrats wenigstens ein Ablagerungssystem CVD, PECVD, PVD, MOCVD oder ein Ätzsystem aufweisen.

## Claims

1. Equipment for fabricating semiconductor wafers, each comprising a substrate (1) covered with at least one layer of materials, said substrate (1) comprising a face to be treated (A) and an untreated face (B), said fabricating equipment comprising:
• a central conveyor module (2) comprising a plurality of lateral ports (3) and conveyor means (4) that can convey said substrate (1) from one lateral port (3) to another, said central conveyor module (2) being capable of functioning under vacuum pressure conditions above 10⁻⁸ Torr;
• a loader module (5) connected to one or more ports (3) of the central conveyor module (2), said loader module (5) being capable of receiving one or more substrates (1); and
• one or more treatment modules (7) for treating the substrate functioning under vacuum pressure conditions above 10⁻⁸ Torr, each treatment module (7) being connected to one of the ports (3) of the central conveyor module (2) and being capable of receiving said substrate (1) in order to carry out a treatment operation on its face to be treated (A), at least one of said substrate treatment modules (7) comprising a system for depositing materials;
**characterized in that** it comprises:
• at least one molecular beam deposition module for depositing materials by evaporation using a molecular beam (6) functioning under vacuum pressure conditions below 10⁻⁸ Torr, said molecular beam deposition module (6) being connected to one of the ports (3) of the central conveyor module (2) and being capable of receiving said substrate (1) in order to deposit a layer of materials on its face to be treated (A), said module for depositing materials by evaporation using a molecular beam (6) includes an airlock (8) connecting it to one of the ports (3) of the central conveyor module (2), said airlock (8) allowing the pressure between the module for depositing materials by evaporation using a molecular beam (6) to be made compatible with the central conveyor module (2), said airlock (8) including an opening (10a, 10b) in each of its lateral ends that can be closed by a valve, and pump means that can provide vacuum pressure conditions below 10⁻⁸ Torr and vacuum pressure conditions above 10⁻⁸ Torr inside the airlock (8) and
• a flipper module (9) that can flip the face to be treated (A) of the substrate (1):
- upwards when the substrate (1) is intended to be transferred to a treatment module (7), wherein the face to be treated (A) of the substrate (1) is oriented towards the upper portion of said treatment module (7), or
- downwards when the substrate (1) is intended to be transferred to a module for depositing materials by evaporation using a molecular beam (6) wherein the face to be treated (A) of the substrate (1) is oriented towards the lower portion of said module (6),
• said flipper module (9) being positioned between one of the ports (3) of the central conveyor module (2) and one of the modules for depositing materials by evaporation using a molecular beam (6), said flipper module (9) being integrated into said airlock (8) and
• said flipper module (9) comprising a flipper means (11) and longitudinal movement means (12) placed between one of said openings (10a, 10b) of the flipper module (9) and the flipper means (11), the longitudinal movement means (12) comprising a support (13) that can support the substrate (1) and that can be moved between a position for unloading or loading the substrate (1) by the flipper means (11) and a position for evacuating or receiving the substrate (1) through one of the openings of the flipper module (10a, 10b), said flipper means (11) being capable of picking up the substrate (1) positioned on the support (13) of the longitudinal movement means, pivoting about a horizontal axis to flip the substrate (1), and unloading it onto another support (15a).

2. Equipment for fabricating semiconductor wafers according to claim 1, **characterized in that** the flipper means (11) comprises pivot means (16) to flip the substrate and gripper means (17) to pick up and release the substrate (1), said gripper means (17) comprising two semi-circular arms (18a, 18b) forming tongs, and articulation means (19) to allow tightening or loosening of the semi-circular arms (18a, 18b) when the flipper means (11) is in the position for loading or unloading the substrate (1).

3. Equipment for fabricating semiconductor wafers according to claim 1 or 2, **characterized in that** the substrate treatment module or modules (7) comprise at least one etcher module or vapor deposition module for performing CVD, PECVD, PVD, or MOCVD.
